(19) Europäisches Patentamt
European Patent Office
Office européen des brevets

(11) **EP 4 358 424 A1**

(12) **DEMANDE DE BREVET EUROPEEN**

(43) Date de publication:
**24.04.2024 Bulletin 2024/17**

(21) Numéro de dépôt: **23202422.4**

(22) Date de dépôt: **09.10.2023**

(51) Classification Internationale des Brevets (IPC):
**H04B 5/00** *(2024.01)*    **G06K 19/07** *(2006.01)*
**H04L 7/033** *(2006.01)*    **H04L 27/00** *(2006.01)*
**H04W 4/80** *(2018.01)*    **H04W 56/00** *(2009.01)*

(52) Classification Coopérative des Brevets (CPC):
**H04B 5/24; G06K 19/0723; H03L 7/087;
H03L 7/093; H04B 5/72; H04B 5/77;
H04L 27/0014; H04W 4/80;** H03L 2207/06

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **21.10.2022 FR 2210964**

(71) Demandeur: **STMicroelectronics France
92120 Montrouge (FR)**

(72) Inventeurs:
• **SIBILLE, Florent
38000 GRENOBLE (FR)**
• **HOUDEBINE, Marc
38920 CROLLES (FR)**

(74) Mandataire: **Casalonga
Casalonga & Partners
Bayerstraße 71/73
80335 München (DE)**

(54) **PROCÉDÉ DE COMMUNICATION SANS CONTACT ENTRE UN OBJET ET UN LECTEUR UTILISANT UNE MODULATION ACTIVE DE CHARGE**

(57)    Selon un aspect, il est proposé un objet configuré pour pouvoir effectuer une communication sans contact avec un lecteur (RD) en utilisant une modulation active de charge, l'objet comprenant :
- des moyens de détection (ANTC) d'un champ d'un lecteur,
- une boucle à verrouillage de phase (PLL) comportant un oscillateur (DCO) et étant configurée pour asservir une phase de l'oscillateur (DCO) sur le champ du lecteur (RD),

- un système de calibration (SYSC) de la fréquence de l'oscillateur (DCO) de la boucle à verrouillage de phase configuré pour calibrer la fréquence de l'oscillateur (DCO) à partir d'une horloge interne (CLKXO) lorsque lesdits moyens de détection détectent un arrêt du champ du lecteur avant la fin d'une initialisation de ladite boucle à verrouillage de phase dudit objet, puis pour ajuster la phase de l'oscillateur (DCO) lorsqu'un nouveau champ du lecteur (RD) est détecté.

[Fig 1]

EP 4 358 424 A1

## Description

Des modes de mise en oeuvre et de réalisation de l'invention concernent la communication en champ proche, c'est-à-dire sans contact.

La communication en champ proche (connu également par l'acronyme NFC de l'anglais « Near field communication ») est une technologie de communication sans fil haute fréquence à faible distance, qui permet des échanges de données entre deux dispositifs sans contact sur une faible distance par exemple de l'ordre de 10 cm.

La technologie NFC est une plateforme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC.

La communication en champ proche peut être réalisée entre un lecteur et un objet pouvant être émulé en mode carte. Le lecteur est alors configuré pour générer un champ magnétique par l'intermédiaire de son antenne qui est généralement dans les normes classiquement utilisées, une onde sinusoïdale à 13,56 MHz. La force du champ magnétique est par exemple comprise entre 0.5 et 7.5 ampères/mètre en moyenne quadratique (c'est-à-dire « RMS » acronyme de l'anglais « Root Mean Square »).

La communication en champ proche peut être réalisée selon un mode de fonctionnement actif. Dans ce mode de fonctionnement, le lecteur et l'objet génèrent tous les deux un champ électromagnétique. Généralement, ce mode de fonctionnement est utilisé lorsque l'objet est pourvu d'une source d'alimentation propre, par exemple une batterie, comme c'est le cas dans un téléphone mobile cellulaire qui est alors émulé en mode carte.

En particulier, la communication en champ proche peut être effectuée en utilisant une modulation active de charge (connue également par l'acronyme « ALM » de l'anglais « Active Load Modulation »). La modulation active de charge requiert une synchronisation des signaux entre le lecteur et l'objet.

Le lecteur est configuré pour émettre un champ électromagnétique, et l'objet est configuré pour moduler une amplitude du champ sans battement. Afin de répondre au lecteur, l'objet génère un signal synchronisé avec le champ du lecteur de façon à être en phase avec le champ du lecteur. Il est alors également important pour le lecteur de générer un champ suffisamment stable pour pouvoir détecter des faibles variations de son champ en fonction de la distance entre le lecteur et l'émulateur de carte.

En mode lecteur ou en mode émulateur de carte, il est important que l'objet génère une horloge la plus propre possible et qui permette d'assurer la communication avec un minimum d'énergie. Pour ce faire, il convient de réduire et même d'éviter la présence de tonalités parasites dans l'horloge générée.

L'objet comporte une boucle à verrouillage de phase. La boucle à verrouillage de phase comprend un oscillateur asservi en phase et en fréquence à partir d'un signal ayant une fréquence de référence qui peut être différente de 13,56 MHz. Le signal ayant la fréquence de référence peut être un signal issu du champ généré par le lecteur. L'oscillateur est asservi de façon à obtenir en sortie de la boucle à verrouillage de phase un signal ayant une fréquence souhaitée, par exemple de 13,56 MHz. L'oscillateur est alors asservi de façon à générer un signal ayant une fréquence multiple de la fréquence souhaitée, par exemple une fréquence de 64x13,56 MHz pour une fréquence souhaitée de 13,56 MHz. L'objet comporte également un circuit permettant de diviser la fréquence du signal généré par l'oscillateur de façon à obtenir un signal à la fréquence souhaitée, par exemple 13,56 MHz.

En particulier, le lecteur est configuré pour émettre régulièrement un champ magnétique de sondage pour initier une communication avec un objet. L'objet est configuré pour asservir l'oscillateur de la boucle à verrouillage de phase sur la fréquence du champ du lecteur. Une fois la fréquence et la phase de l'oscillateur calibrées, alors l'objet est configuré pour répondre en générant un champ magnétique ayant la même fréquence et la même phase que le champ magnétique de sondage du lecteur à partir du signal d'horloge généré en sortie de la boucle à verrouillage de phase pour communiquer avec le lecteur.

Généralement, le champ magnétique de sondage du lecteur est émis suffisamment longtemps, par exemple pendant une période de 5 millisecondes, pour que l'objet initialise ses régulateurs à faible décrochage et pour que la boucle à verrouillage de phase finisse d'asservir son oscillateur sur le champ du lecteur.

Néanmoins, certains lecteurs ont un fonctionnement qui ne respectent pas complètement la technologie NFC.

En particulier, on connaît des lecteurs qui sont configurés pour sonder la présence d'une carte de manière de manière très rapide, par rapport aux normes de la technologie NFC. Un tel lecteur est configuré pour sonder régulièrement si une carte est présente à proximité du lecteur. Pour ce faire, de la même manière que décrit précédemment, le lecteur émet un champ magnétique qu'il module afin d'émettre une requête de réponse puis attend une réponse si une carte est présente à proximité. Néanmoins, un tel lecteur est configuré pour émettre son champ pendant une courte durée avant d'envoyer sa requête de réponse. Or, pendant cette courte période, un objet émulé en mode carte n'a pas le temps de s'initialiser pour verrouiller la phase et la fréquence de son champ sur le champ du lecteur. Dans ce cas, le lecteur ne reçoit pas de réponse de l'objet même si ce dernier est présent à proximité du lecteur. L'objet ne peut alors pas commencer une communication avec le lecteur.

Il existe donc un besoin de proposer un procédé permettant à un objet de pouvoir communiquer avec un lecteur sondant rapidement la présence d'une carte à proximité.

Selon un aspect, il est proposé un procédé de communication sans contact entre un objet et un lecteur utilisant une modulation active de charge, le procédé comprenant :

- une émission par le lecteur d'un champ magnétique de sondage, puis
- une détection d'un champ magnétique de sondage par ledit objet,
- une initialisation d'une boucle à verrouillage de phase dudit objet, le procédé comprenant en outre :
- une détection d'un arrêt du champ du lecteur avant la fin de l'initialisation de ladite boucle à verrouillage de phase dudit objet,
- une calibration de l'oscillateur de la boucle à verrouillage de phase de l'objet à partir d'une horloge interne dudit objet, puis
- une détection d'un nouveau champ magnétique de sondage du lecteur, puis
- une mise en oeuvre de la boucle à verrouillage de phase pour ajuster la phase de l'oscillateur afin de permettre audit objet de répondre au lecteur.

Un tel procédé permet d'initialiser la fréquence de l'oscillateur de la boucle à verrouillage de phase de l'objet lorsqu'un lecteur à sondage rapide est détecté. Cette initialisation permet de définir la fréquence de l'oscillateur de la boucle à verrouillage de phase à partir d'une horloge interne de l'objet. Ainsi, la boucle à verrouillage de phase est préparée pour émettre plus rapidement une réponse au lecteur lorsque celui-ci émet un nouveau champ pour sonder la présence de l'objet. En effet, lors de la détection du nouveau champ, l'objet peut seulement ajuster la phase du signal généré sur celle du champ généré par le lecteur, car la fréquence de signal généré par l'oscillateur de la boucle à verrouillage de phase est déjà celle souhaitée. En particulier, la calibration de fréquence de l'oscillateur peut prendre entre 200 $\mu$s (microsecondes) et 300 $\mu$s alors que l'ajustement de la phase de l'oscillateur peut prendre simplement entre 10 $\mu$s et 20 $\mu$s. En répondant au lecteur dans la période de sondage du lecteur, l'objet peut initialiser une communication avec le lecteur.

Un tel procédé permet donc à un objet de pouvoir communiquer avec un lecteur même si le temps d'initialisation de sa boucle à verrouillage de phase est plus long que la période de sondage du lecteur.

Dans un mode de mise en oeuvre avantageux, la calibration de l'oscillateur est réalisée en mesurant une fréquence en sortie de l'oscillateur puis en comparant la fréquence mesurée à une fréquence souhaitée, puis en calibrant la fréquence de l'oscillateur en fonction d'un résultat de la comparaison.

En variante, la calibration de l'oscillateur est réalisée en utilisant une boucle à verrouillage de fréquence pour asservir la fréquence de l'oscillateur sur la fréquence de l'horloge interne.

En particulier, la calibration peut comporter une mise en oeuvre de la boucle à verrouillage de fréquence pour calibrer et asservir la fréquence de l'oscillateur à partir d'une valeur stockée dans un registre, lorsqu'un arrêt du champ magnétique de sondage du lecteur est détecté avant la fin d'une initialisation. De préférence, la boucle à verrouillage de phase est mise en oeuvre lorsqu'un nouveau champ magnétique de sondage du lecteur est détecté pour ajuster la phase de l'oscillateur. Avantageusement, la boucle à verrouillage de phase est mise en oeuvre lorsqu'un nouveau champ magnétique de sondage du lecteur est détecté pour asservir la boucle à verrouillage de fréquence qui contrôle l'oscillateur.

Selon un autre aspect, il est proposé un objet configuré pour pouvoir effectuer une communication sans contact avec un lecteur en utilisant une modulation active de charge, l'objet comprenant :

- une horloge interne,
- des moyens de détection configurés pour détecter un champ magnétique de sondage d'un lecteur,
- une boucle à verrouillage de phase comportant un oscillateur et étant configurée pour asservir une phase de l'oscillateur sur le champ magnétique détecté du lecteur, la boucle à verrouillage de phase étant configurée pour être initialisée lorsqu'un champ magnétique de sondage est détecté par lesdits moyens de détection,
- un système de calibration de la fréquence de l'oscillateur de la boucle à verrouillage de phase configuré pour calibrer la fréquence de l'oscillateur à partir de l'horloge interne lorsque lesdits moyens de détection détectent un arrêt du champ magnétique de sondage du lecteur avant la fin d'une initialisation de ladite boucle à verrouillage de phase dudit objet, puis pour ajuster la phase de l'oscillateur lorsqu'un nouveau champ magnétique de sondage du lecteur est détecté afin de pouvoir répondre au lecteur.

Dans un mode de réalisation avantageux, le système de calibration est configuré pour mesurer une fréquence en sortie de l'oscillateur et pour comparer la fréquence mesurée à une fréquence souhaitée, puis pour calibrer la fréquence de l'oscillateur en fonction d'un résultat de la comparaison.

En variante, le système de calibration comporte une boucle à verrouillage de fréquence configurée pour asservir la fréquence de l'oscillateur sur la fréquence de l'horloge interne.

Avantageusement, le système de calibration est configuré pour :

- mettre en oeuvre la boucle à verrouillage de fréquence pour calibrer et asservir la fréquence de l'oscillateur à partir d'une valeur stockée dans un registre, lorsque lesdits moyens de détection détectent un arrêt du champ magnétique de sondage du lecteur avant la fin d'une initialisation de ladite boucle à verrouillage de phase dudit objet, puis

- mettre en oeuvre la boucle à verrouillage de phase lorsqu'un nouveau champ magnétique de sondage du lecteur est détecté pour ajuster la phase de l'oscillateur afin de pouvoir répondre au lecteur.

De préférence, le système de calibration est configuré pour mettre en oeuvre la boucle à verrouillage de phase lorsqu'un nouveau champ magnétique de sondage du lecteur est détecté pour asservir la boucle à verrouillage de fréquence qui contrôle l'oscillateur.

D'autres avantages et caractéristiques de l'invention apparaîtront à l'examen de la description détaillée de modes de réalisation, nullement limitatifs, et des dessins annexés sur lesquels :

[Fig 1]
[Fig 2]
[Fig 3]
[Fig 4]
[Fig 5]
[Fig 6]

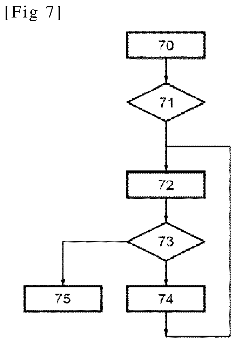

[Fig 7] illustrent des modes de réalisation et de mise en oeuvre de l'invention.

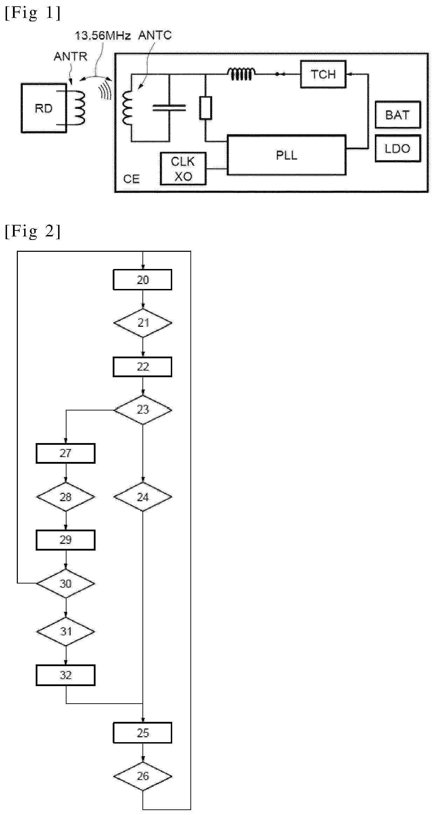

La figure 1 illustre un mode de réalisation d'un système SYS de communication en champ proche. Le système SYS comporte un lecteur RD et un objet CE pouvant être émulé en mode carte pour une communication en champ proche. L'objet CE peut être un téléphone multifonctions, une montre connectée... L'objet CE est configuré pour communiquer en utilisant une modulation active de charge (connue également par l'acronyme « ALM » de l'anglais « Active Load Modulation »). La modulation active de charge requiert une synchronisation des signaux entre le lecteur RD et l'objet CE.

En particulier, le lecteur RD comporte une antenne ANTR configurée pour générer un champ magnétique ayant une fréquence donnée, notamment de l'ordre de 13,56MHz.

L'objet CE comporte une antenne ANTC configurée pour recevoir le champ magnétique émis par le lecteur RD et pour émettre un champ magnétique. L'objet comporte également une batterie BAT permettant d'alimenter ses différents éléments.

L'objet CE comporte une boucle à verrouillage de phase PLL. La boucle à verrouillage de phase PLL comprend un oscillateur DCO. Cet oscillateur DCO peut être un oscillateur à commande numérique ou à commande analogique. Par exemple, l'oscillateur à commande numérique peut être un générateur de créneaux (en anglais « ring oscillator »), notamment un oscillateur en anneau. La boucle à verrouillage de phase PLL est configurée pour asservir l'oscillateur DCO en phase et en fréquence sur la fréquence et la phase du champ du lecteur. La boucle à verrouillage de phase PLL permet ainsi de générer un signal ayant la même fréquence et la même phase que celles du lecteur.

L'objet CE comporte également une chaîne de transmission TCH configurée pour mettre en forme les signaux à émettre via l'antenne pour communiquer avec le lecteur. La chaîne de transmission utilise le signal d'horloge pour générer un signal à émettre ayant la même fréquence et la même phase que le champ du lecteur.

L'objet CE comporte au moins un régulateur à faible décrochage (connu également par l'expression « régulateur LDO » de l'anglais « low-dropout regulator ») configurés pour alimenter la boucle à verrouillage de phase

L'objet CE comporte un mode de consommation réduite dans laquelle certains de ses circuits ne sont pas alimentés en énergie, notamment le régulateur LDO alimentant la boucle à verrouillage de phase.

L'objet CE est configuré pour sortir du mode de consommation réduite lorsqu'il reçoit un champ magnétique émis par un lecteur RD.

En particulier, l'objet CE est configuré pour initialiser sa boucle à verrouillage de phase PLL lorsqu'il reçoit un champ du lecteur RD. Si le champ magnétique de sondage du lecteur est émis pendant une durée suffisante pour que la boucle à verrouillage de phase PLL soit initialisée, alors l'objet CE est configuré pour recevoir la requête du lecteur RD et y répondre afin d'entamer une communication en utilisant le signal d'horloge généré par la boucle à verrouillage de phase PLL asservit sur le champ du lecteur RD.

En variante, le lecteur RD peut être un lecteur à sondage rapide. Le champ magnétique de sondage du lecteur est alors émis sur une durée insuffisante pour permettre l'initialisation de la boucle à verrouillage de phase PLL de l'objet CE.

Néanmoins, dans le mode de réalisation illustré, l'objet CE est tout de même configuré pour communiquer avec un lecteur RD à sondage rapide.

En particulier, l'objet CE est configuré pour détecter si un champ reçu s'arrête avant la fin de l'initialisation de la boucle à verrouillage de phase PLL. Dans ce cas, l'objet CE sait que le lecteur RD est un lecteur à sondage rapide.

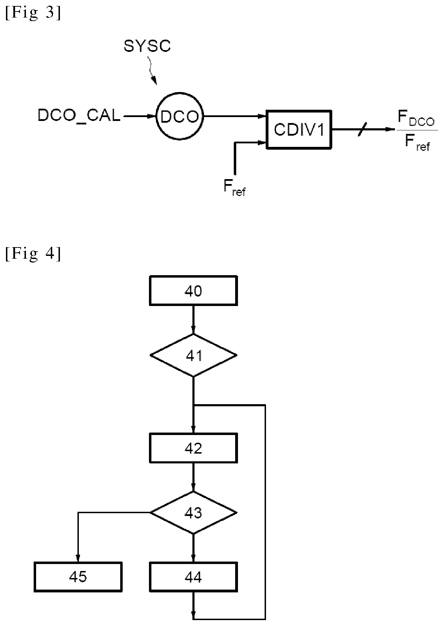

Si l'objet CE a détecté que le lecteur RD est un lecteur à sondage rapide, l'objet CE est configuré pour calibrer la fréquence de l'oscillateur DCO de la boucle à verrouillage de phase PLL en utilisant une fréquence d'un signal généré par une horloge interne CLKXO. Il existe différentes manières pour réaliser la calibration de l'oscillateur DCO de la boucle à verrouillage de phase PLL. Les figures 3 à 6 décrites dans la suite illustrent deux manières différentes pour réaliser cette calibration.

Une fois l'oscillateur calibré, l'objet CE est configuré pour attendre une prochaine émission d'un champ magnétique de sondage du lecteur RD.

Une fois le nouveau champ magnétique de sondage du lecteur RD détecté par l'objet CE, ce dernier est configuré pour mettre en oeuvre la boucle à verrouillage de phase PLL pour calibrer la phase de l'oscillateur de la boucle à verrouillage de phase PLL sur la phase du champ magnétique de sondage. Lorsque la phase de l'oscillateur DCO est calibrée, l'objet CE est configuré pour entamer une communication avec le lecteur RD.

La figure 2 illustre un procédé mis en oeuvre par un objet CE, tel que celui décrit précédemment, pour communiquer avec un lecteur RD dans une communication sans contact.

Le procédé comprend une étape 20 dans laquelle l'objet CE est dans son mode de consommation réduite.

Le procédé comprend également un test 21 dans laquelle l'objet CE détecte un champ du lecteur RD.

Ensuite, si l'objet CE détecte un champ du lecteur RD au test 21, alors le procédé comprend une étape 22 d'initialisation de l'objet CE. Pendant cette étape d'initialisation de l'objet CE, ce dernier active les différents éléments nécessaires pour entamer une communication avec le lecteur RD. Par exemple, l'objet CE active un régulateur LDO. L'activation du régulateur LDO permet d'alimenter la boucle à verrouillage de phase PLL. Lors de l'étape 22 d'initialisation, l'objet CE effectue une calibration et un verrouillage de la boucle à verrouillage de phase PLL sur la fréquence et la phase du champ magnétique.

Puis, le procédé comprend un test 23 de détermination de la présence d'un champ du lecteur RD. Dans cette étape, l'objet CE évalue si le champ du lecteur RD est toujours détecté ou non.

Si l'objet CE détecte que le champ du lecteur RD est toujours présent, alors l'objet CE en déduit que le lecteur RD est configuré pour sonder suffisamment longtemps pour permettre une initialisation de l'objet CE.

Ainsi, dans ce cas, le procédé comporte un test 24 permettant de savoir si la calibration et le verrouillage de la boucle à verrouillage de phase PLL sont terminés.

Une fois la fréquence et la phase de l'oscillateur DCO de la boucle à verrouillage verrouillée sur la fréquence et la phase du champ magnétique, et si le champ du lecteur RD est toujours présent, le procédé comprend une étape 25 de communication dans laquelle l'objet CE communique avec le lecteur RD.

Une fois la communication terminée, l'objet CE détecte la fin du champ du lecteur RD au test 26, puis retourne à l'étape 20 dans son mode de consommation réduite jusqu'à la prochaine détection de champ magnétique.

Si à l'étape 22 (initialisation de l'objet CE comportant la calibration de la boucle à verrouillage de phase) le champ disparait, alors l'objet CE ne détecte plus le champ du lecteur RD lors du test 23. L'objet CE en déduit donc que le lecteur RD est un lecteur à sondage qui n'est pas configuré pour sonder suffisamment longtemps pour permettre une initialisation de l'objet CE.

Dans ce cas, le procédé comporte une étape 27 dans laquelle la boucle à verrouillage de phase PLL est mise en oeuvre pour asservir l'oscillateur DCO sur une fréquence souhaitée, par exemple de l'ordre de 64*13,56MHz à partir d'une horloge interne de l'objet CE. En particulier, l'horloge interne peut être configurée pour générer un signal d'horloge de fréquence comprise entre 13MHz et 76MHz. Le procédé comporte un test 28 permettant de vérifier que l'oscillateur est bien calibré sur la fréquence souhaitée.

Ensuite, une fois l'oscillateur DCO calibré sur la fréquence souhaitée, le procédé comporte une étape 29 dans laquelle l'objet CE démarre un compteur de temps dans l'attente d'une prochaine détection de champ.

Le procédé comporte ensuite un test 30 dans lequel la valeur du compteur de temps est évaluée par rapport à une durée prédéterminée. Si le compteur de temps atteint la durée prédéterminée sans que l'objet CE ne détecte à un test 31 un champ magnétique, alors l'objet CE considère que le lecteur RD ne se situe plus à proximité. L'objet CE retourne alors dans son mode de consommation réduite de l'étape 20.

Si l'objet CE détecte au test 31 un champ magnétique avant la fin de ladite durée prédéterminée, alors le procédé comporte une étape 32 dans laquelle la boucle de verrouillage de phase PLL asservit la fréquence et la phase de l'oscillateur DCO sur la fréquence et la phase du champ magnétique.

Une fois la fréquence et la phase de l'oscillateur DCO asservie, le procédé comprend une étape de communication dans laquelle l'objet CE communique avec le lecteur RD.

Une fois la communication terminée, l'objet CE détecte la fin du champ du lecteur RD au test 26, puis retourne à l'étape 20 dans son mode de consommation réduite jusqu'à la prochaine détection de champ magnétique.

Un tel procédé permet d'initialiser la fréquence de l'oscillateur DCO de la boucle à verrouillage de phase de l'objet CE lorsqu'un lecteur RD à sondage rapide est détecté. Cette initialisation permet de définir la fréquence de l'oscillateur DCO de la boucle à verrouillage de phase PLL à partir d'une horloge interne CLKXO de l'objet. Ainsi, la boucle à verrouillage de phase PLL est préparée pour que l'objet CE puisse émettre plus rapidement une réponse au lecteur lorsque celui-ci émet une nouvelle requête de réponse pour sonder la présence d'une carte. En effet, lors de la détection du nouveau champ, l'objet CE peut seulement ajuster la phase du signal généré sur celle du champ généré par le lecteur, car la fréquence de signal généré par l'oscillateur DCO de la boucle à verrouillage de phase PLL est déjà celle souhaitée. En particulier, la calibration de fréquence de l'oscillateur peut prendre entre 200 μs (microsecondes) et 300 μs alors que l'ajustement de la phase de l'oscillateur peut prendre simplement entre 10 μset 20 μs. En répondant au lecteur RD dans la période de sondage du lecteur, l'objet peut communiquer avec le lecteur.

Un tel procédé permet donc à l'objet CE de pouvoir communiquer avec un lecteur RD même si le temps d'initialisation de sa boucle à verrouillage de phase PLL est plus long que la période de sondage du lecteur RD.

La figure 3 illustre un premier mode de réalisation d'un système de contrôle de l'oscillateur DCO de la boucle à verrouillage de phase PLL permettant d'asservir l'oscillateur DCO à partir d'une horloge interne lorsque le champ détecté provient d'un lecteur à sondage rapide RD. En particulier, l'objet CE est configuré pour contrôler la fréquence de l'oscillateur DCO de la boucle à verrouillage de phase PLL avec une valeur de contrôle dco_cal. L'oscillateur DCO présente une sortie connectée à une première entrée d'un compteur-diviseur CDIV1. Le compteur-diviseur CDIV1 comporte également une deuxième entrée configurée pour recevoir un signal d'horloge de fréquence Fref. Ce signal d'horloge est généré par une horloge interne de l'objet CE. Le compteur diviseur CDIV1 est configuré pour générer un signal

$$\frac{F_{DCO}}{F_{ref}}.$$

L'objet CE est configuré pour mettre en oeuvre une machine avec un nombre fini d'états. Cette machine avec un nombre fini d'états permet de définir la valeur de contrôle dco_cal. En particulier, la figure 4 illustre un procédé pouvant être mis en oeuvre par la machine avec un nombre fini d'états pour contrôler l'oscillateur DCO de la boucle à verrouillage de phase PLL. En particulier, le procédé comporte une étape 40 dans laquelle le système de contrôle est en mode de consommation réduite et initialise le contrôle de la calibration de l'oscillateur dco_cal à sa valeur minimale. Le procédé comporte ensuite un test 41 qui permet de démarrer la calibration de la boucle à verrouillage de phase requise à l'étape 22 précédemment décrite.

Le procédé comporte ensuite une étape 42 de mesure de la fréquence en sortie de l'oscillateur DCO de la boucle à verrouillage de phase PLL.

Puis, le procédé comporte un test 43 dans lequel la fréquence mesurée en sortie de l'oscillateur DCO est comparée à la fréquence souhaitée, par exemple de l'ordre de 64*13.56MHz. Si la fréquence mesurée est inférieure à la fréquence souhaitée, alors le procédé comprend une étape 44 dans laquelle la valeur de contrôle est incrémentée de façon à augmenter la fréquence de l'oscillateur DCO. Suite à l'incrémentation, une mesure de la fréquence est de nouveau effectuée afin de vérifier si la fréquence de l'oscillateur a atteint sa valeur.

Si la fréquence de l'oscillateur atteint la fréquence souhaitée, alors la calibration se termine à l'étape 45.

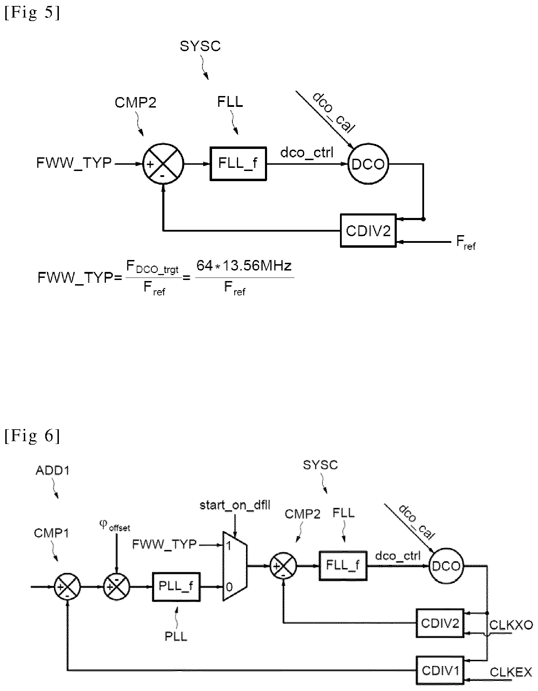

La figure 5 illustre un deuxième mode de réalisation d'un système de contrôle de l'oscillateur DCO de la boucle à verrouillage de phase PLL permettant d'asservir l'oscillateur DCO à partir d'une horloge interne lorsque le champ détecté provient d'un lecteur à sondage rapide RD.

Le système de contrôle est une boucle à verrouillage de fréquence FLL configurée pour recevoir en entrée une valeur FWW_TYP. Cette valeur FWW_TYP peut notamment être stockée dans un registre. La valeur FWW_TYP est une valeur prédéfinie égale à $\frac{\overline{F_{DCO\_trgt}}}{F_{ref}}$, où $F_{DCO\_trgt}$ correspond à la fréquence souhaitée pour l'oscillateur, par exemple 64*13,56MHz, $F_{ref}$ correspond à la fréquence de l'horloge interne.

Le système de contrôle est réalisé par une boucle à verrouillage de fréquence FLL contrôlant le même oscillateur DCO que la boucle à verrouillage de phase. La boucle à verrouillage de fréquence PLL comporte un compteur-diviseur CDIV2. Le compteur-diviseur CDIV2 comporte une première entrée connectée à la sortie de l'oscillateur DCO, et une deuxième entrée configurée pour recevoir le signal d'horloge de fréquence de référence Fref généré par l'horloge interne CLKXO. Le compteur diviseur CDIV2 est configuré pour générer un signal $\frac{F_{DCO}}{F_{ref}}$. La boucle à verrouillage de fréquence FLL comporte également un comparateur CMP2 présentant une première entrée non inverseuse configurée pour recevoir la valeur FWW_TYP, et une deuxième entrée configurée pour recevoir le signal $\frac{F_{DCO}}{F_{ref}}$. La boucle à verrouillage de fréquence FLL comporte également un filtre de boucle FLL_f présentant une entrée connectée à la sortie du comparateur, et une sortie connectée à l'oscillateur DCO.

La figure 6 illustre la boucle à verrouillage de fréquence du système de contrôle intégrée avec la boucle à verrouillage de phase pour contrôler le même oscillateur DCO. Dans cet exemple, l'oscillateur DCO est configuré pour sortir un signal d'oscillateur de sortie ayant une fréquence égale à N* 13,56 MHZ. N est de préférence un nombre entier égal ou supérieur à 1, par exemple égal à 64. N pourrait être également fractionnaire avantageusement en association avec un convertisseur delta sigma pour récupérer la valeur moyenne.

La boucle à verrouillage de phase PLL comprend un filtre de boucle PLL_f, l'oscillateur commandé DCO, et un premier compteur-diviseur CNT1 recevant d'une part le signal de sortie de l'oscillateur et d'autre part le signal d'horloge CLKEX extrait du champ du lecteur.

La sortie du premier compteur-diviseur CDIV1 est rebouclée via un premier comparateur CMP1. Par ailleurs, éventuellement, un additionneur ADD1 permet d'ajouter un déphasage $\phi_{offset}$, représentatif du déphasage provoqué par les moyens disposés entre l'antenne ANTC et la boucle à verrouillage de phase PLL.

La boucle à verrouillage de fréquence FLL comprend ici comme décrit précédemment le filtre de boucle FLL_f, l'oscillateur DCO, le compteur-diviseur CDIV2 recevant à une extrémité le signal de sortie de l'oscillateur DCO et à une autre extrémité un signal d'horloge de référence CLKXO à la fréquence de référence Fref délivré par l'horloge interne CLKXO de l'objet CE.

Les deux filtres de boucle PLL_f et FLL_f sont ici des filtres qui ont une structure classique (intégrant typiquement des filtres stabilisateurs) et, afin d'éviter au maximum tout problème de stabilité, de préférence conçus de telle sorte que la fréquence de coupure de la boucle FLL soit supérieure à la fréquence de coupure de la boucle PLL. Ainsi les réponses temporelles des deux boucles PLL et PLL sont pilotées par la boucle PLL.

La sortie du compteur CDIV2 est rebouclée sur l'entrée du filtre de boucle FLL_f via et un comparateur CMP2.

Dans le cas présent, alors que la sortie du premier compteur CDIV1 délivre le déphasage entre le signal de sortie de l'oscillateur et le signal d'horloge CLEX extrait du champ du lecteur, une des bascules du compteur CDIV1 permet de délivrer le signal d'horloge DVCLK dont la fréquence est divisée par N, par exemple ici 64, par rapport à la fréquence du signal DCOS de manière à obtenir la fréquence de 13,56 MHz à ladite tolérance près.

Un commutateur est en outre placé entre le filtre de boucle PLL_f et le comparateur CMP2. Le commutateur comporte une première entrée '0' configurée pour être connectée à la sortie du filtre de boucle PLL_f, et une deuxième entrée '1' configurée pour recevoir la valeur FWW_TYP. Le commutateur comporte également une entrée configurée pour recevoir le signal de sélection start_on_dfll. Le commutateur présente une sortie connectée à l'entrée de la boucle à verrouillage de fréquence. Le signal en sortie du commutateur correspond ainsi à la valeur en sortie du filtre de boucle PLL_f lorsque la valeur du signal de sélection start_on_dfll est égale à 0 et à la valeur FWW_TYP lorsque la valeur du signal de sélection start_on_dfll est égale à 1.

Le commutateur est configuré pour permettre un fonctionnement uniquement de la boucle à verrouillage de fréquence en l'absence de champ du lecteur (la valeur du signal de sélection est alors égale à 1).

Le commutateur est configuré pour permettre un fonctionnement de la boucle à verrouillage de phase lorsque le nouveau champ magnétique de sondage du lecteur est détecté.

La figure 7 illustre un procédé mis en oeuvre par le système de contrôle pour contrôler l'oscillateur DCO de la boucle à verrouillage de phase PLL en utilisant la boucle à verrouillage de fréquence FLL. En particulier, le procédé comporte une étape 70 dans laquelle le système de contrôle est en mode de consommation réduite et initialise le contrôle de l'oscillateur dco_cal à une valeur minimum. Le procédé comporte ensuite un test 71 qui permet de démarrer la calibration de la boucle à verrouillage de phase requise à l'étape 22 précédemment décrite Pour calibrer la boucle à verrouillage de phase, le système de contrôle exécute à l'étape 72 la boucle à verrouillage de fréquence pendant une durée prédéterminée à partir de la valeur FWW_TYP. Ensuite, le procédé comporte un test 73 dans lequel la valeur dco_ctrl de contrôle de l'oscillateur est comparée à la valeur de la fréquence centrale dco_mid, notamment 64*13,56MHz. Le test 73 permet de laisser le temps à la boucle à verrouillage de fréquence de se stabiliser. Si la valeur dco_ctrl de contrôle de l'oscillateur est inférieure à la valeur dco_mid, cela signifie que la fréquence de l'oscillateur est inférieure à la fréquence souhaitée. Si la fréquence de l'oscillateur est inférieure à la fréquence souhaitée, alors le procédé comporte une étape 74 dans laquelle la valeur dco_cal est incrémentée, avant de laisser à nouveau le temps à la boucle à verrouillage de fréquence de tenter de stabiliser la fréquence de l'oscillateur, pour centrer la fréquence de l'oscillateur sur la fréquence centrale, notamment de 64*13,56MHz. Si la valeur dco_ctrl de contrôle n'est plus inférieure à la valeur dco_mid au test73 de comparaison, cela signifie que l'oscillateur a atteint la fréquence souhaitée. La calibration se termine alors à l'étape 75.

Dans ce mode de mise en oeuvre, l'oscillateur est contrôlé par la boucle à verrouillage de fréquence FLL. Néanmoins, en variante, l'oscillateur peut être contrôlé seulement par la boucle à verrouillage de phase PLL.

**Revendications**

1. Procédé de communication sans contact entre un objet (CE) et un lecteur (RD) utilisant une modulation active de charge, le procédé comprenant :

   - une émission par le lecteur (RD) d'un champ magnétique de sondage, puis
   - une détection d'un champ magnétique de sondage par ledit objet (CE),
   - une initialisation d'une boucle à verrouillage de phase (PLL) dudit objet (CE),

   le procédé comprenant en outre :

   - une détection d'un arrêt du champ du lecteur (RD) avant la fin de l'initialisation de ladite boucle à verrouillage de phase dudit objet (CE),
   - une calibration de l'oscillateur (DCO) de la boucle à verrouillage de phase de l'objet à partir d'une horloge interne (CLKXO) dudit objet, puis
   - une détection d'un nouveau champ magnétique de sondage du lecteur, puis
   - une mise en oeuvre de la boucle à verrouillage de phase pour ajuster la phase de l'oscillateur (DCO) afin de permettre audit objet de répondre au lecteur.

2. Procédé selon la revendication 1, dans lequel la calibration de l'oscillateur (DCO) est réalisée en mesurant une fréquence en sortie de l'oscillateur (DCO) puis en comparant la fréquence mesurée à une fréquence souhaitée, puis en calibrant la fréquence de l'oscillateur (DCO) en fonction d'un résultat de la comparaison.

3. Procédé selon la revendication 1, dans lequel la calibration de l'oscillateur (DCO) est réalisée en utilisant une boucle à verrouillage de fréquence (FLL) pour asservir la fréquence de l'oscillateur (DCO) sur la fréquence de l'horloge interne (CLKXO).

4. Procédé selon la revendication 3, dans lequel la calibration comporte une mise en oeuvre de la boucle à verrouillage de fréquence (FLL) pour calibrer et asservir la fréquence de l'oscillateur à partir d'une valeur (FWW_TYP) stockée dans un registre, lorsqu'un arrêt du champ magnétique de sondage du lecteur est détecté avant la fin d'une initialisation, et dans lequel la boucle à verrouillage de phase est mise en oeuvre lorsqu'un nouveau champ magnétique de sondage du lecteur (RD) est détecté pour ajuster la phase de l'oscillateur (DCO).

5. Procédé selon la revendication 4, dans lequel la boucle à verrouillage de phase est mise en oeuvre lorsqu'un nouveau champ magnétique de sondage du lecteur (RD) est détecté pour asservir la boucle à verrouillage de fréquence (FLL) qui contrôle l'oscillateur (DCO).

6. Objet configuré pour pouvoir effectuer une communication sans contact avec un lecteur en utilisant une modulation active de charge, l'objet comprenant :

    - une horloge interne (CLKXO),
    - des moyens de détection (ANTC) configurés pour détecter un champ magnétique de sondage d'un lecteur,
    - une boucle à verrouillage de phase (PLL) comportant un oscillateur (DCO) et étant configurée pour asservir une phase de l'oscillateur (DCO) sur le champ magnétique détecté du lecteur (RD), la boucle à verrouillage de phase étant configurée pour être initialisée lorsqu'un champ magnétique de sondage est détecté par lesdits moyens de détection (ANTC),
    - un système de calibration (SYSC) de la fréquence de l'oscillateur (DCO) de la boucle à verrouillage de phase configuré pour calibrer la fréquence de l'oscillateur (DCO) à partir de l'horloge interne (CLKXO) lorsque lesdits moyens de détection détectent un arrêt du champ magnétique de sondage du lecteur avant la fin d'une initialisation de ladite boucle à verrouillage de phase dudit objet, puis pour ajuster la phase de l'oscillateur (DCO) lorsqu'un nouveau champ magnétique de sondage du lecteur (RD) est détecté afin de pouvoir répondre au lecteur (RD).

7. Objet selon la revendication 6, dans lequel le système de calibration (SYSC) est configuré pour mesurer une fréquence en sortie de l'oscillateur (DCO) et pour comparer la fréquence mesurée à une fréquence souhaitée, puis pour calibrer la fréquence de l'oscillateur (DCO) en fonction d'un résultat de la comparaison.

8. Objet selon la revendication 7, dans lequel le système de calibration (SYSC) comporte une boucle à verrouillage de fréquence configurée pour asservir la fréquence de l'oscillateur (DCO) sur la fréquence de l'horloge interne (CLKXO).

9. Objet selon la revendication 8, dans lequel le système de calibration (SYSC) est configuré pour :

    - mettre en oeuvre la boucle à verrouillage de fréquence pour calibrer et asservir la fréquence de l'oscillateur à partir d'une valeur (FWW_TYP) stockée dans un registre, lorsque lesdits moyens de détection détectent un arrêt du champ magnétique de sondage du lecteur avant la fin d'une initialisation de ladite boucle à verrouillage de phase dudit objet, puis
    - mettre en oeuvre la boucle à verrouillage de phase lorsqu'un nouveau champ magnétique de sondage du lecteur (RD) est détecté pour ajuster la phase de l'oscillateur (DCO) afin de pouvoir répondre au lecteur (RD).

10. Objet selon la revendication 9, dans lequel le système de calibration (SYSC) est configuré pour mettre en oeuvre la boucle à verrouillage de phase lorsqu'un nouveau champ magnétique de sondage du lecteur (RD) est détecté pour asservir la boucle à verrouillage de fréquence qui contrôle l'oscillateur (DCO).

[Fig 1]

[Fig 2]

[Fig 3]

[Fig 4]

[Fig 5]

$$FWW\_TYP = \frac{F_{DCO\_trgt}}{F_{ref}} = \frac{64 * 13.56 MHz}{F_{ref}}$$

[Fig 6]

[Fig 7]

Europäisches Patentamt
European Patent Office
Office européen des brevets

**RAPPORT DE RECHERCHE EUROPEENNE**

Numéro de la demande

**EP 23 20 2422**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CHOKE TIENG YING ET AL: "A 3.4Mbps NFC card emulator supporting 40mm2 loop antenna", 2017 IEEE RADIO FREQUENCY INTEGRATED CIRCUITS SYMPOSIUM (RFIC), IEEE, 4 juin 2017 (2017-06-04), pages 244-247, XP033115793, DOI: 10.1109/RFIC.2017.7969063 * page 244 – page 246; figures 1, 3, 4-5 * | 1-10 | INV. H04B5/00 G06K19/07 H04L7/033 H04L27/00 H04W4/80 H04W56/00 |
| X | US 2019/230611 A1 (HOUDEBINE MARC [FR]) 25 juillet 2019 (2019-07-25) * alinéa [0067] – alinéa [0099]; figure 1 * * alinéa [0117] – alinéa [0137]; figures 6-7 * | 1-10 | |
| A | US 2018/110018 A1 (YU RUI [SG] ET AL) 19 avril 2018 (2018-04-19) * alinéa [0039] – alinéa [0046]; figure 1 * * alinéa [0061] – alinéa [0079]; figure 6 * | 1-10 | DOMAINES TECHNIQUES RECHERCHES (IPC) H04B H04L H04W G06K |

Le présent rapport a été établi pour toutes les revendications

| Lieu de la recherche | Date d'achèvement de la recherche | Examinateur |
|---|---|---|
| Munich | 29 février 2024 | Cabañas Prieto, Ana |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 23 20 2422

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-02-2024

| Document brevet cité au rapport de recherche | Date de publication | Membre(s) de la famille de brevet(s) | Date de publication |
|---|---|---|---|
| US 2019230611 A1 | 25-07-2019 | CN 110061763 A | 26-07-2019 |
| | | FR 3077174 A1 | 26-07-2019 |
| | | US 2019230611 A1 | 25-07-2019 |
| US 2018110018 A1 | 19-04-2018 | CN 107707278 A | 16-02-2018 |
| | | EP 3337049 A1 | 20-06-2018 |
| | | SG 10201608437W A | 30-05-2018 |
| | | US 2018110018 A1 | 19-04-2018 |

Pour tout renseignement concernant cette annexe : voir Journal Officiel de l'Office européen des brevets, No.12/82